# EUROPÄISCHE PATENTSCHRIFT

(11) **EP 3 078 992 B1**
(45) Veröffentlichungstag und Bekanntmachung des Hinweises auf die Patenterteilung: **30.01.2019**
(21) Anmeldenummer: 15001019.7
(22) Anmeldetag: 10.04.2015
(51) Int. Cl.: G01W 1/10, G01W 1/16, G01W 1/14

(54) **SYSTEM UND VERFAHREN ZUR IDENTIFIKATION UND/ODER VORHERSAGE VON HAGELEREIGNISSEN**
SYSTEM AND METHOD FOR THE IDENTIFICATION AND/OR PREDICTION OF HAIL EVENTS
SYSTÈME ET PROCÉDÉ D'IDENTIFICATION ET/OU DE PRÉVISION DE CHUTES DE GRÊLES

(43) Veröffentlichungstag der Anmeldung: 12.10.2016
(73) Patentinhaber: nowcast GmbH, 81369 München (DE)
(72) Erfinder: Möhrlein, Matthias, 81379 München (DE); Riso, Silvia, 81369 München (DE); Betz, Hans-Dieter Prof. Dr., 86938 Schondorf (DE); Betz, Daniel, 86938 Schondorf (DE)
(74) Vertreter: DTS Patent- und Rechtsanwälte Schnekenbühl und Partner mbB

(56) Entgegenhaltungen:
- WO-A1-2013/006259
- Wen Yao ET AL: "Characteristics of lightning activities in the hailstorm using the data from two types of lightning detection network", 22nd International Lightning Detection Conference, 1. April 2012 (2012-04-01), XP055212201, Gefunden im Internet: URL:http://www.vaisala.com/en/events/ildci lmc/Documents/Severe/Characteristics of Lightning Activities in the Hailstorm Using the Data from Two Types.pdf [gefunden am 2015-09-09]
- PATRICK N. GATLIN ET AL: "A Total Lightning Trending Algorithm to Identify Severe Thunderstorms", JOURNAL OF ATMOSPHERIC AND OCEANIC TECHNOLOGY, Bd. 27, Nr. 1, 1. Januar 2010 (2010-01-01) , Seiten 3-22, XP055212203, ISSN: 0739-0572, DOI: 10.1175/2009JTECHA1286.1
- EARLE WILLIAMS ET AL: "The behavior of total lightning activity in severe Florida thunderstorms", ATMOSPHERIC RESEARCH, Bd. 51, Nr. 3-4, 1. Juli 1999 (1999-07-01) , Seiten 245-265, XP055212208, ISSN: 0169-8095, DOI: 10.1016/S0169-8095(99)00011-3

## Beschreibung

Die vorliegende Erfindung betrifft ein System und ein Verfahren zur Identifikation und/oder Vorhersage von Hagelereignissen.

Das Auftreten von Hagel kann zu schweren Schäden an z.B. Gebäuden und Fahrzeugen führen und im schlimmsten Fall auch Menschenleben gefährden. Es besteht daher ein erhebliches Interesse daran, z.B. vor dem Auftreten von Hagel rechtzeitig warnen zu können.

Aus der DE 10 2004 000 025 A1 ist bereits ein System zum Erfassen, Übermitteln und Auswerten von durch elektromagnetische Strahlung anfallenden Daten und Informationen bekannt. Dieses System ermöglicht eine genaue Charakterisierung von z.B. Wolke-Boden-Blitzen und Wolke-Wolke-Blitzen innerhalb einer Wolke oder zwischen Wolken. Eine dreidimensionale Peilung von Impulsabgaben/-aussendungen natürlichen und/oder nichtnatürlichen Ursprungs, insbesondere von Blitzen, Ladungsabgaben, von Ladungsaussendungen oder von dergleichen in Niederfrequenznetzwerken (sog. very-low-frequency-networks bzw. VLF-Netzwerken) wird ermöglicht. Als Langwellen (englisch very low frequency, kurz VLF) bezeichnet man elektromagnetische Wellen im Frequenzbereich von 3 bis 30 kHz. Dabei ist keine Nutzung von Frequenzen im Radio- oder VHF-Bereich (englisch very high frequency, kurz VHF) erforderlich.

Aus der WO 2013/006259 A1 ist weiter ein Unwetterwarnsystem bekannt, das Daten im Zusammenhang mit Blitzaktivität auswertet und Ort, Bewegungsgeschwindigkeit, Bewegungsrichtung, Blitzrate von einer oder mehreren Zellen von Blitzaktivität bestimmt. Sodann wird die Blitzrate verglichen mit einem Schwellwert und ein oder mehrere geographische Bereiche werden bestimmt auf der Grundlage von Ort, Bewegungsgeschwindigkeit und Bewegungsrichtung der Gewitterzellen.

Der Zusammenhang des Auftretens von Gewittern und Hagelereignissen ist bereits bekannt. Allerdings ist, wie dies auch gemeinhin bekannt ist, nicht bei jedem Gewitterereignis auch gleichzeitig ein Hagelereignis zu erwarten.

Es ist daher die Aufgabe der vorliegenden Erfindung, ein System zur Identifikation und/oder Vorhersage von Unwettern der eingangs genannten Art in vorteilhafter Weise weiterzubilden, insbesondere dahingehend, dass Hagelereignisse mit größerer Genauigkeit vorhergesagt werden können.

Diese Aufgabe wird erfindungsgemäß gelöst durch ein System zur Identifikation und/oder Vorhersage von Hagelereignissen mit den Merkmalen des Anspruchs 1.

Die Erfindung basiert auf dem Grundgedanken, gezielt Daten im Zusammenhang mit Gewittern dahingehend zu überprüfen, ob es zum Auftreten von Ereignissen kommt, die in engem Zusammenhang mit dem Auftreten von Hagel stehen. Ein derartiges Ereignis ist beispielsweise das Auftreten eines sogenannten Blitzsprungs. Dabei ist der Begriff Blitzsprung (engl. "lightning jump") als ein Ereignis definiert, bei dem es zu einem (starken) Anstieg von Blitzaktivität und/oder zu einem (starken) Anstieg der Emissionshöhen von Wolkeblitzen zu einem bestimmten Zeitpunkt (und an einem bestimmten Ort) kommt. Anhand eines derartigen Blitzsprungereignisses kann mit hoher Wahrscheinlichkeit das Auftreten von Hagel vorhergesagt werden. Wenn man also mittels eines z.B. aus der DE 10 2004 000 025 A1 bekannten Systems zur Blitzortung, insbesondere eines dreidimensionalen Systems zur Blitzanalyse und Blitzortung die mittels dieses Systems erhaltenen Daten zusätzlich auf das Auftreten von Blitzsprungereignissen untersucht, so kann man mit sehr großer Genauigkeit das Auftreten von Hagelereignissen vorhersagen. Die Blitzsignalanalyse kann eine dreidimensionale Analyse sein. Dabei können Bodenblitze als auch Wolke-Wolke-Blitze oder innerhalb einer Wolke auftretende Blitze analysiert werden.

Die Erfassung der aktuellen Gewittersituation erfolgt durch Messung der in der Gegenwart auftretenden (Teil-) Blitze ("strokes"). Die Messung der "strokes" erfolgt dabei durch die Messstationen, die die elektromagnetische Strahlung der "strokes" erfasst und - mit einem exakten Zeitstempel (beispielsweise ungefähr 10 Nanosekunden) mittels der Zeitmesseinrichtung versieht - kontinuierlich an die Auswerteeinheit versendet. Mithilfe eines TOA-Verfahrens (englisch time of arrival, kurz TOA) kann mittels des Blitzsignalanalysemoduls aus den Signalen die exakte Position eines einzelnen "strokes" ermittelt werden. Dabei kann zwischen sog. Wolke-(IC) und Bodenblitzen (CG) unterschieden werden.

Die Messstationen können beispielsweise ein Messnetz ausbilden und z.B. im Großraum Europa über 100 hochsensitive Sensoren aufweisen. Denkbar ist beispielsweise, das Messnetz LINET der nowcast GmbH zu nutzen.

Ein Gesamtblitz ("flash") besteht meist aus mehreren Teilblitzen ("strokes"). Mit dem sog. Algorithmus "strokes to flashes" werden die "strokes" zu "flashes" zusammengefasst. Ein Gesamtblitz kann aus einer Kombination von IC ("Wolke-Blitze") und CG ("Bodenblitze") bestehen. Häufungen von "flashes" und "strokes" (zeitlich und räumlich) können zu einer Blitzzelle ("cell") zusammengefasst werden. Die Berechnung der "cells" kann in regelmäßigen Zeitabständen oder kontinuierlich erfolgen. Dadurch kann die Fortbewegung der "cell" ermittelt werden. "Cells" können sich dabei teilen und vereinen sowie auflösen.

Bei der dreidimensionalen Blitzsignalanalyse werden sämtliche bspw. in einem Zeitraum in einem bestimmten dreidimensionalen Raum auftretenden Blitze hinsichtlich Blitzaktivität, Blitzanzahl, Blitzstärke, Ort des Blitzes, Bewegungsrichtung (der Gewitterzelle), Bewegungsgeschwindigkeit der Blitze bzw. der Zelle/cell ermittelt. Des Weiteren kann vorgesehen sein, dass die Blitzsignalanalyse Daten betreffend Blitzaktivität und/oder Blitzanzahl bzw. Blitzintensität und/oder Blitzstärke und/oder Ort und/oder Bewegungsrichtung und/oder Bewegungsgeschwindigkeit der Blitze aufweist. Anhand von Daten betreffend die Blitzaktivität, Blitzanzahl bzw. Blitzintensität, Blitzstärke, Ort, Bewegungsrichtung oder Bewegungsgeschwindigkeit der Blitze kann jeweils für sich genommen oder in Kombination mittels des zweiten Blitzsignalanalysemoduls genauer ein Blitzsprungereignis aufgefunden werden.

Dabei soll nicht nur anhand einer zeitlichen und örtlichen Häufung von Blitzen auf ein Blitzsprungereignis geschlossen werden, sondern es soll anhand der in die Blitzsignalanalyse eingegangenen Daten wenigstens ein Blitzsprungereignis auf der Grundlage des Vorliegens eines Gradienten ermöglichen, wobei der Gradient sich insbesondere aus den in die Blitzsignalanalyse eingehenden Daten ergibt.

Insbesondere kann weiter vorgesehen sein, dass die Blitzsignalanalyse Daten betreffend Wolke-Blitze und Boden-Blitze aufweist. Diese Daten betreffend Wolke-Blitze und Boden-Blitze stehen im Zusammenhang mit dem Vorliegen eines Blitzsprungereignisses und können da zur genaueren Identifizierung eines solchen Blitzsprungereignisses herangezogen werden.

Darüber hinaus ist möglich, dass die Blitzsignalanalyse Daten betreffend die Höhe der Blitze, insbesondere eine Höhenverteilung der Blitze aufweist. Durch die Berücksichtigung der Höhe der Blitze, insbesondere durch die Berücksichtigung einer Höhenverteilung der Blitze wird es in besonderem Maße ermöglicht oder erleichtert, das Vorliegen von Gradienten zu identifizieren, die auf das Vorliegen eines Blitzsprungereignisses hinsichtlich Rate und/oder Höhe hinweisen.

Daten betreffend die Höhenverteilung der Blitzen können beispielsweise Daten betreffend die Emissionshöhen von Blitzen umfassen.

Insbesondere kann es sich um Daten handeln, aus denen ableitbar ist, ob es zu einem (starken) Anstieg der Emissionshöhen von Wolkeblitzen gekommen ist oder nicht.

Außerdem kann vorgesehen sein, dass das zweite Blitzsignalanalysemodul wenigstens ein erstes Vergleichselement und wenigstens ein zweites Vergleichselement aufweist, wobei mittels des ersten und zweiten Vergleichselements jeweils unabhängig voneinander ein Blitzsprungereignis ermittelbar ist und durch das zweite Blitzsignalanalysemodul ein Blitzsprungereignis ermittelt wird, wenn beide Vergleichselemente ein Blitzsprungereignis ermitteln.

Dadurch wird es möglich, erst dann auf das Vorliegen eines Blitzsprungereignisses zu schließen, wenn zwei voneinander unabhängige Identifizierungsmethoden und Identifizierungselemente in Form des ersten und zweiten Vergleichselementes zu dem Ergebnis gekommen sind, dass ein Blitzsprungereignis vorliegt. Dadurch kann die Sensitivität der Identifizierung von Hagelereignissen verbessert werden.

Des Weiteren kann vorgesehen sein, dass mittels des zweiten Blitzsignalanalysemoduls anhand der zeitlichen Koordinaten des Blitzsprungorts Koordinaten des Blitzsprungereignisses ermittelbar sind. Denkbar ist beispielsweise, dass anhand des in der DE 10 2004 000 025 A1 beschriebenen Laufzeitverfahrens anhand der zeitlichen Koordinaten der Blitze die Ortskoordinaten der Blitze ermittelbar sind, und basierend hierauf die zeitlichen Koordinaten des Blitzsprungereignisses und auf dieser Grundlage wiederum die Ortskoordinaten des Blitzsprungereignisses ermittelt werden können.

Ferner ist denkbar, dass mittels des zweiten Blitzsignalanalysemoduls ausgehend von den ermittelten Ortskoordinaten des Blitzsprungereignisses wenigstens ein wahrscheinliches Hagelniederschlagsgebiet identifizierbar ist. Durch die Identifizierung eines wahrscheinlichen Hagelniederschlagsgebietes wird es möglich, eine gezielte Warnung im Hinblick auf einen wahrscheinlichen Hagelniederschlag aussprechen zu können.

Des Weiteren ist denkbar, dass mittels des zweiten Blitzsignalanalysemoduls ein mögliches Hagelniederschlagsgebiet zusätzlich anhand von Signalen betreffend Blitze im Zeitraum nach dem Blitzsprungereignis eingrenzbar ist. Denkbar ist beispielsweise, anhand von zeitlicher und örtlicher Verteilung der Blitze sowie anhand der örtlichen Koordinaten des Blitzsprungereignisses und der Bewegungsrichtung und Bewegungsgeschwindigkeit auf ein mögliches Hagelniederschlagsgebiet zu schließen. In diesem Zusammenhang kann als Faustformel gelten, dass ausgehend von der Identifizierung zu einem Zeitpunkt t = 0 Minuten ein mögliches Hagelniederschlagsgebiet insbesondere an der Stelle wahrscheinlich ist, zu der die entsprechende Gewitterzelle mit dem wenigstens einen Blitzsprungereignis sich nach ca. 8 bis 12 Minuten, insbesondere ca. 10 Minuten später hinbewegt hat.

Des Weiteren betrifft die vorliegende Erfindung ein Verfahren zur Identifikation und/oder Vorhersage von Hagelereignissen, mit den Merkmalen des Anspruchs 8.

Sämtliche im Zusammenhang mit dem vorstehend beschriebenen erfindungsgemäßen System sowie seiner möglichen Ausführungsformen können sämtliche strukturellen und funktionellen Merkmale allein oder in Kombination auch beim erfindungsgemäßen Verfahren vorgesehen sein und die damit in Zusammenhang stehenden Vorteile erzielt werden.

Des Weiteren kann vorgesehen sein, dass die Blitzsignalanalyse Daten betreffend Blitzaktivität und/oder Blitzanzahl bzw. Blitzintensität und/oder Blitzstärke und/oder Ort und/oder Bewegungsrichtung und/oder Bewegungsgeschwindigkeit der Blitze und/oder Wolke-Blitze und/oder Boden-Blitze und/oder Daten betreffend die Höhe der Blitze, insbesondere eine Höhenverteilung der Blitze, aufweist.

Darüber hinaus kann vorgesehen sein, dass wenigstens auf zwei unterschiedliche Ermittlungsarten jeweils unabhängig voneinander ein Blitzsprungereignis ermittelt wird und ein Blitzsprungereignis erst dann ermittelt wird, wenn gemäß beiden Ermittlungsarten ein Blitzsprungereignis ermittelt wurde.

Außerdem ist denkbar, dass anhand der zeitlichen Koordinaten des Blitzsprungorts Koordinaten des Blitzsprungereignisses ermittelt werden.

Ferner ist denkbar, dass mittels des zweiten Blitzsignalanalysemoduls ausgehend von den ermittelten Ortskoordinaten des Blitzsprungereignisses wenigstens ein wahrscheinliches Hagelniederschlagsgebiet identifizierbar ist.

Außerdem ist denkbar, dass ein mögliches Hagelniederschlagsgebiet zusätzlich anhand von Signalen betreffend Blitze im Zeitraum nach dem Blitzsprungereignis eingegrenzt wird.

Weitere Einzelheiten und Vorteile der Erfindung sollen nun anhand eines in den Zeichnungen dargestellten Ausführungsbeispiels näher erläutert werden.

Es zeigen:
- Figur 1:: eine schematische Darstellung eines Ausführungsbeispiels eines erfindungsgemäßen Systems gemäß der vorliegenden Erfindung, das nach dem Verfahren gemäß der vorliegenden Erfindung arbeitet;
- Figur 2:: ein Flussdiagramm des erfindungsgemäßen Verfahrens;
- Figur 3:: ein erster Schritt der Auswertung der aufgenommenen Blitze zur Identifizierung eines Blitzsprungereignisses;
- Figur 4:: die Auswertung der Blitzereignisse auf zwei unterschiedliche Arten;
- Figur 5:: die Ermittlung von Blitzsprungereignissen anhand der unterschiedlichen Auswertemethoden;
- Figur 6:: die schematische Darstellung der Übertragung der ermittelten Ergebnisse gemäß Figur 5 mit geographischen Daten, hier einer Landkarte; sowie
- Figur 7:: die schematische Darstellung einer um zeitliche Einflüsse korrigierten Karte gemäß Figur 6 mit der Identifizierung einer Region, in der ein Hagelereignis wahrscheinlich ist.

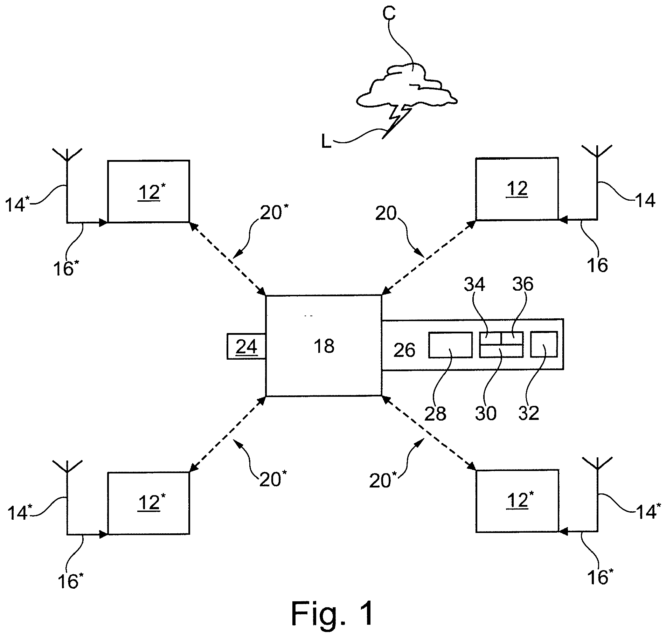

Figur 1 zeigt in schematischer Darstellung, ein System 10 zur Identifizierung und Vorhersage von Hagelereignissen mit mehren Messstationen 12, 12*, wobei die Messstationen 12, 12* zur Erfassung von Signalen betreffend elektromagnetische Strahlung im Zusammenhang mit Blitzen ist.

Jeder Messstation 12, 12* ist jeweils wenigstens eine Antenneneinheit 14 zugeordnet, die mit der jeweiligen Messstation 12, 12* über entsprechende Datenübertragungsmittel 16, 16* Rohdaten betreffend Blitze L übertragen können.

Das System 10 weist weiter wenigstens eine Zentralstation 18 auf, die über eine entsprechende Datenverbindung 20, 20* mit jeder einzelnen Messstation 12, 12* verbunden ist.

In der Zentralstation 18 ist eine Zeitmesseinrichtung 24 zur Erfassung des zeitlichen Verlaufs der erfassten Signale, die mittels der Messstation 12, 12* erfasst werden, vorgesehen. Darüber hinaus ist grundsätzlich denkbar, dass auch jede einzelne Messstation 12, 12* mit einer entsprechenden Zeitmesseinrichtung 24 versehen ist.

Weiter weist die Zentralstation 18 wenigstens eine Auswerteeinheit 26 auf.

Die Auswerteeinheit 26 weist dabei ein erstes Blitzsignalanalysemodul 28 zur Erstellung einer Blitzsignalanalyse auf der Grundlage der mittels der Messstation 12, 12* erfassten Signale auf.

Darüber hinaus weist die Auswerteeinheit 26 ein zweites Blitzsignalanalysemodul 30 zur Identifizierung von wenigstens einem Blitzsprungereignis auf der Grundlage des zeitlichen Verlaufs der erfassten Signale und der Blitzsignalanalyse auf, wobei die Auswerteeinheit 26 weiter ein Vorhersagemodul 32 zur Vorhersage betreffend ein Hagelereignis auf der Grundlage eines Blitzsprungereignisses aufweist.

Das zweite Blitzsignalanalysemodul 30 weist wenigstens ein erstes Vergleichselement 34 und wenigstens ein zweites Vergleichselement 36 auf, wobei mittels des ersten und zweiten Vergleichselements 34, 36 jeweils unabhängig voneinander ein Blitzsprung ermittelbar ist und durch das zweite Blitzsignalanalysemodul 30 ein Blitzsprung ermittelt wird, wenn beide Vergleichselemente ein Blitzsprungereignis ermitteln.

Im System 10 ist in der Auswerteeinheit 26 in einem separaten Speicher Informationsmaterial betreffend die Messstationen 12, 12* hinterlegt, insbesondere deren Ortskoordinaten.

Die Zeitmesseinrichtung 24 kann beispielsweise eine Zeitmesseinrichtung sein, die eine hochgenaue GPS-Zeitbasis nutzt.

Im Hinblick auf den genauen Aufbau und die Funktionsweise des Systems 10 kann beispielhaft auf die DE 10 2004 000 025 A1 verwiesen werden, die den grundsätzlichen strukturellen und funktionellen Aufbau eines Blitzortungssystems für die sog. Dreidimensionale Blitzortung beschreibt, das für das erfindungsgemäße System zur Identifikation und/oder Vorhersage von Hagelereignissen als technische Grundlage dienen kann. Erfindungsgemäß tritt nunmehr aber hinzu, dass die Auswerteeinheit ein zweites Blitzsignalanalysemodul 30 zur Identifizierung von wenigstens einem Blitzsprungereignis auf der Grundlage des zeitlichen Verlaufs der erfassten Signale und der Blitzsignalanalyse aufweist und dass die Auswerteeinheit ein Vorhersagemodul 32 zu einer Vorhersage betreffend ein Hagelereignis auf der Grundlage eines Blitzsprungereignisses aufweist.

Erfindungsgemäß wird zur Identifikation und Vorhersage von Hagelereignissen nunmehr folgendermaßen vorgegangen:
Es werden in einem ersten Schritt Signale betreffend die elektromagnetische Strahlung im Zusammenhang mit Blitzen L erfasst. In Figur 1 ist exemplarisch ein Blitz L aus einer Wolke C gezeigt.

Sodann wird der zeitliche Verlauf der erfassten Signale erfasst.

Auf der Grundlage dieser Signale wird sodann eine Blitzsignalanalyse wenigstens aufweisend Daten betreffend Blitzaktivität, Blitzanzahl, Blitzstärke, Ort, Bewegungsrichtung und Bewegungsgeschwindigkeit erstellt.

Des Weiteren gehen in die Blitzsignalanalyse Daten betreffend Wolke-Blitze und Boden-Blitze auf, wobei insbesondere auch das Verhältnis von Wolke-Blitzen und Boden-Blitzen bei der Blitzsignalanalyse berücksichtigt wird.

Des Weiteren gehen in die Blitzsignalanalyse Daten betreffend die Höhe der Blitze, insbesondere auch eine Höhenverteilung der Blitze ein.

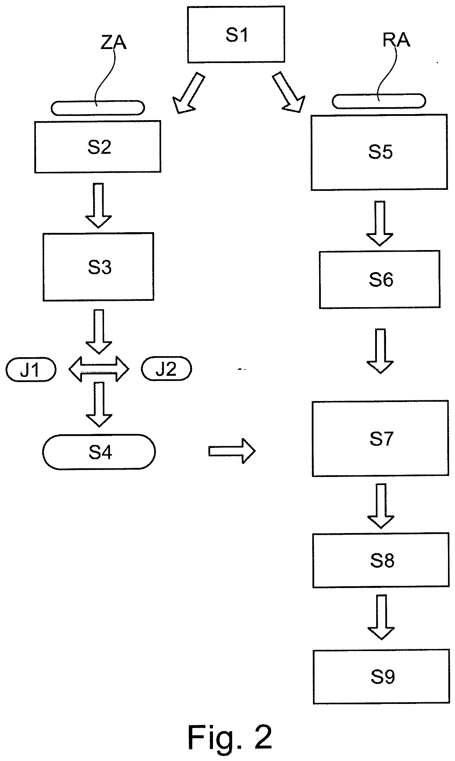

Figur 2 zeigt schematisch ein Ablaufschema des erfindungsgemäßen Verfahrens, wie es in einem erfindungsgemäßen System verwendet werden kann:
Im Schritt S1 werden die Rohdaten, die in die Blitzsignalanalyse einfließen, gesammelt und der Auswertung zugeführt, wobei in den Schritten S2, S3 und S4 eine zeitliche Analyse ZA dieser Daten erfolgt.
Im Schritt S2 wird ein Histogramm erstellt, bei dem die Blitzrate zeitlich eingetragen wird.
Im Schritt S3 wird nach einem Blitzsprungereignis gesucht.
Im Schritt S4 werden den Blitzsprungereignissen Zeitkoordinaten zugeordnet. Die Blitzsprungereignisse, die in Schritt 3 ermittelt werden, werden mit J1 und J2 in Figur 2 dargestellt.

In den Schritten S5, S6 und S7 wird eine räumliche Analyse RA durchgeführt.

Es wird in Schritt S5 mittels einer Rastermatrix eine Blitzdichtekarte erstellt.

Darüber hinaus wird in Schritt S6 der Weg des Sturmes, der die im Zusammenhang mit den Blitzen in Verbindung stehenden Wolken bewegt, ermittelt.

In Schritt S7 wird das Sprungereignis in Zusammenhang mit den breiteren Längekoordinaten mit den Breitengrad- und Längengradkoordinaten in Zusammenhang gesetzt, um im Zusammenhang mit den zeitlichen Koordinaten sodann die örtlichen und zeitlichen Charakteristiken des Blitzsprungereignisses zu ermitteln.

In Schritt S8 werden sodann Bereiche identifiziert, in denen es zu einem Blitzsprungereignis gekommen ist.

Anhand dieses ermittelten Gebietes wird sodann in Schritt S9 ein Gebiet G identifiziert, in dem es mit hoher Wahrscheinlichkeit zu einem Hagelereignis kommen kann.

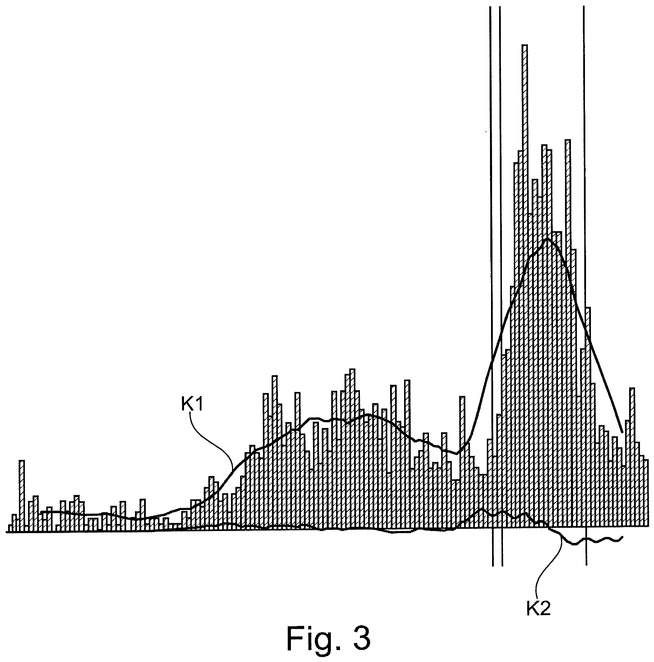

Figur 3 zeigt ein Histogramm der Blitzrate pro Minute eines Sturmes.

Wie in Figur 3 gezeigt, werden zwei Kurven eingetragen, wobei die Kurve K1 der Durchschnittswert der Blitzrate pro Zeiteinheit ist. Die Kurve K2 ist der Gradient, der im Zusammenhang mit der Blitzrate steht.

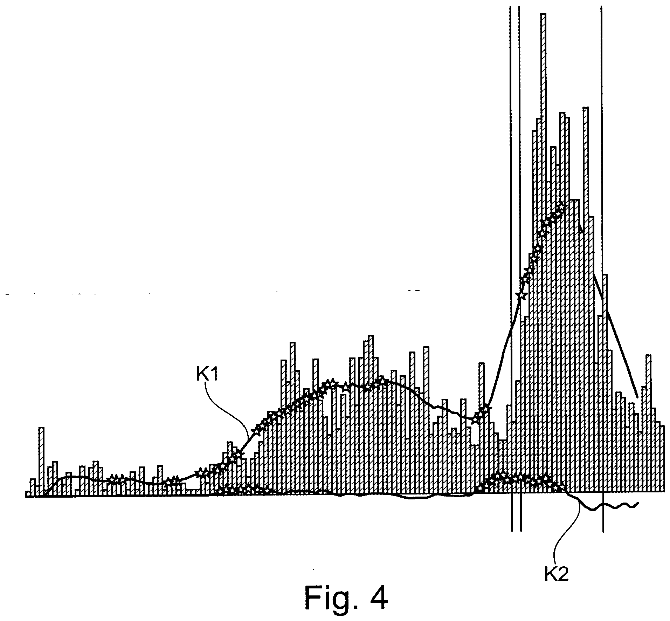

Figur 4 zeigt in den Kurven K1 und K2 mittels Sternen in den jeweiligen Kurven K1 und K2 identifizierte Maxima, die als potentielle Blitzsprungereignisse in Betracht kommen.

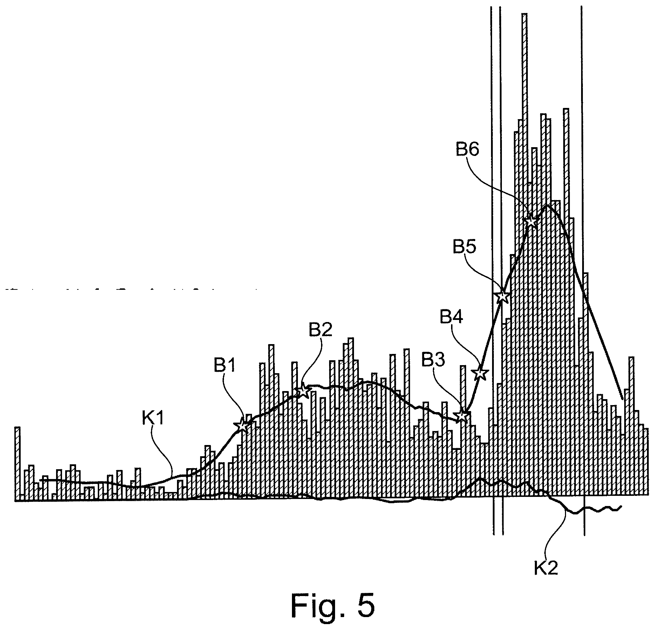

Wie in Figur 5 gezeigt, wird nur an den Stellen, an denen jeweils in beiden Kurven K1, K2 auch das Vorliegen eines Blitzsprungereignisses geschlossen werden kann, tatsächlich auch auf ein Blitzsprungereignis B1, B2, B3, B4, B5, B6 geschlossen.

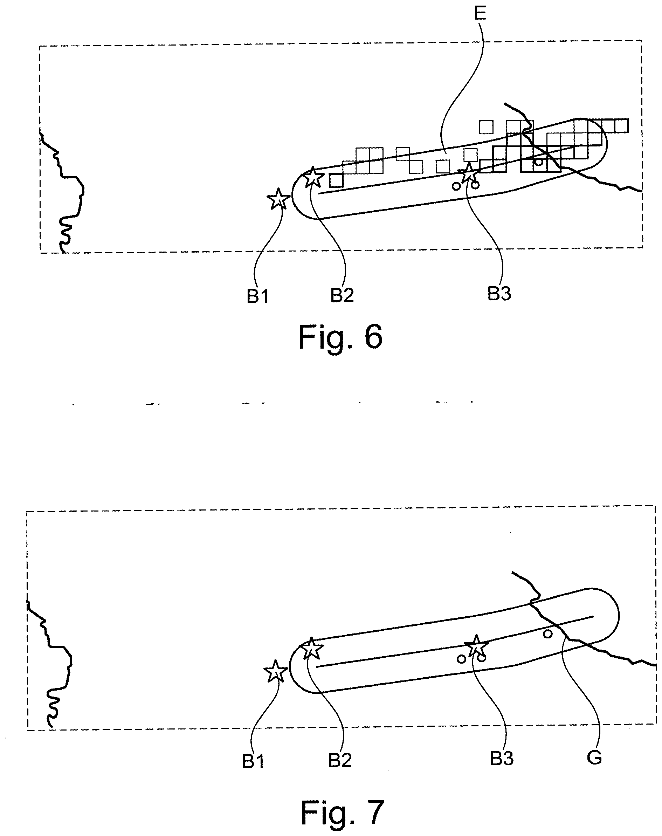

Wie in Figur 6 gezeigt, wird durch das in Figur 5 ermittelte Ergebnis (vgl. auch Figur 2 und Schritte S3, S4 und S7) eine Karte erstellt, in der die Blitzsprungereignisse B1, B2 und B3 räumlich und zeitlich eingetragen sind.

Bei der Identifizierung der Blitzsprungereignisse können die Emissionshöhen von Wolkeblitzen miteinbezogen werden. Als Blitzsprungereignis kann dabei insbesondere im Zusammenhang mit einem Ausführungsbeispiel der Erfindung ein Ereignis definiert werden, bei dem es zu einem (starken) Anstieg von Blitzaktivität und/oder zu einem (starken) Anstieg der Emissionshöhen von Wolkeblitzen kommt.

Nach derartigen Ereignissen werden die vorliegenden Rohdaten gezielt durchsucht bzw. dahingehend analysiert. Dadurch kann die Genauigkeit in Bezug auf die Ermittlung von Blitzsprungereignissen erheblich gesteigert werden.

Vorzugsweise wird nach Ereignissen gesucht, bei denen es sowohl zu einem (starken) Anstieg von Blitzaktivität und einem (starken) Anstieg der Emissionshöhen von Wolkeblitzen kommt.

Figur 6 zeigt dabei die Karte zum Zeitpunkt t₀= n Minuten.

Da bekanntermaßen ein Hagelereignis erst mit einer gewissen zeitlichen Verzögerung nach einem Blitzsprungereignis B1, B2 und B3 auftritt, kann ein zeitlicher Korrekturfaktur k = m Minuten, beispielsweise k = 10 Minuten, eingesetzt werden.

Figur 7 zeigt dabei die aus Figur 6 bekannte Karte zum Zeitpunkt t₁= n + k, also gemäß Beispiel hier t₁= n + 10 Minuten, wobei anhand der Bewegungsrichtung des Sturmpfades (vgl. Figur 2, Schritt S6) die Bewegungsrichtung der Wolken, die mit dem Blitzsprungereignis B1, B2 und B3 in Verbindung stehen, berücksichtigt wird. Folglich kann aus dem in Figur 6 gezeigten sog. Blitzsprungereignisbereich E auf ein Gebiet G geschlossen werden, das eine hohe Wahrscheinlichkeit im Hinblick auf ein Hagelereignis hat (vgl. auch Figur 2, Schritt S 9). Ein derartiges Gebiet wird auch als wahrscheinliches Hagelniederschlagsgebiet G bezeichnet.

## Patentansprüche

1. System (10) zur Identifikation und/oder Vorhersage von Hagelereignissen mit mehreren Messstationen (12, 12*) zur Erfassung von Signalen betreffend elektromagnetische Strahlung im Zusammenhang mit Blitzen, mit wenigstens einer Zeitmesseinrichtung (24) zur Erfassung des zeitlichen Verlaufs der erfassten Signale, mit wenigstens einer Auswerteeinheit (26), die mit den Messstationen (12, 12*) und der Zeitmesseinrichtung (24) verbunden ist, wobei die Auswerteeinheit (26) wenigstens ein erstes Blitzsignalanalysemodul (28) zur Erstellung einer Blitzsignalanalyse auf der Grundlage der erfassten Signale aufweist,
wobei die Auswerteeinheit (26) ein zweites Blitzsignalanalysemodul (30) zur Identifizierung von wenigstens einem Blitzsprungereignis (J1, J2) auf der Grundlage des zeitlichen Verlaufs der erfassten Signale und der Blitzsignalanalyse aufweist und dass die Auswerteinheit (26) ein Vorhersagemodul (32) (J1, J2) zu einer Vorhersage betreffend ein Hagelereignis auf der Grundlage eines Blitzsprungereignisses aufweist, **dadurch gekennzeichnet, dass** die Blitzsignalanalyse Daten betreffend die Höhe der Blitze, insbesondere eine Höhenverteilung der Blitze aufweist, wobei bei der Identifizierung des Blitzsprungereignisses die Emissionshöhe von Wolkeblitzen mit einbezogen wird und wobei als Blitzsprungereignis ein Ereignis definiert wird, bei dem es zu einem starken Anstieg von Blitzaktivität und/oder einem starken Anstieg der Emissionshöhen von Wolkeblitzen kommt.

2. System (10) nach Anspruch 1, **dadurch gekennzeichnet, dass** die Blitzsignalanalyse Daten betreffend Blitzaktivität und/oder Blitzanzahl bzw. Blitzintensität und/oder Blitzstärke und/oder Ort und/oder Bewegungsrichtung und/oder Bewegungsgeschwindigkeit der Blitze aufweist.

3. System (10) nach Anspruch 1 oder Anspruch 2, **dadurch gekennzeichnet, dass** die Blitzsignalanalyse Daten betreffend Wolke-Blitze und Boden-Blitze aufweist.

4. System (10) nach einem der vorhergehenden Ansprüche, **dadurch gekennzeichnet, dass** zweite Blitzsignalanalysemodul (30) wenigstens ein erstes Vergleichselement (34) und wenigstens ein zweites Vergleichselement (36) aufweist, wobei mittels des ersten und zweiten Vergleichselements (34, 36) jeweils unabhängig voneinander ein Blitzsprungereignis (J1, J2) ermittelbar ist und durch das zweite Blitzsignalanalysemodul (30) ein Blitzsprungereignis (J1, J2) ermittelt wird, wenn beide Vergleichselemente ein Blitzsprungereignis (J1, J2) ermitteln.

5. System (10) nach einem der vorhergehenden Ansprüche, **dadurch gekennzeichnet, dass** mittels des zweiten Blitzsignalanalysemoduls (30) anhand der zeitlichen Koordinaten des Blitzsprungereignisses (J1, J2) Ortskoordinaten des Blitzsprungereignisses (J1, J2) ermittelbar sind.

6. System (10) nach Anspruch 5, **dadurch gekennzeichnet, dass** mittels des zweiten Blitzsignalanalysemoduls (30) ausgehend von den ermittelten Ortskoordinaten des Blitzsprungereignisses wenigstens ein wahrscheinliches Hagelniederschlagsgebiet (G) identifizierbar ist.

7. System (10) nach einem der vorhergehenden Ansprüche, **dadurch gekennzeichnet, dass** mittels des zweiten Blitzsignalanalysemoduls (30) ein mögliches Hagelniederschlagsgebiet (G) zusätzlich anhand von Signalen betreffend Blitze im Zeitraum nach dem Blitzsprung eingrenzbar ist.

8. Verfahren zur Identifikation und/oder Vorhersage von Hagelereignissen, wobei das Verfahren wenigstens die folgenden Schritte aufweist:
- es werden Signale betreffend elektromagnetische Strahlung im Zusammenhang mit Blitzen erfasst;
- es wird der zeitliche Verlauf der erfassten Signale erfasst;
- auf der Grundlage der erfassten Signale wird eine Blitzsignalanalyse aufweisend Daten betreffend Blitzaktivität und/oder Blitzanzahl und/oder Blitzstärke und/oder Emissionshöhe von Blitzen und/oder Ort und/oder Bewegungsrichtung und/oder Bewegungsgeschwindigkeit der Blitze erstellt; wobei auf der Grundlage der Blitzsignalanalyse wenigstens ein Blitzsprungereignis (J1, J2) identifiziert und auf der Grundlage eines Blitzsprungereignisses (J1, J2) eine Vorhersage betreffend ein Hagelereignis bereitgestellt wird, **dadurch gekennzeichnet, dass** die Blitzsignalanalyse Daten betreffend die Höhe der Blitze, insbesondere eine Höhenverteilung der Blitze, aufweist, wobei bei der Identifizierung des Blitzsprungereignisses die Emissionshöhe von Wolkeblitzen mit einbezogen wird und wobei als Blitzsprungereignis ein Ereignis definiert wird, bei dem es zu einem starken Anstieg von Blitzaktivität und/oder einem starken Anstieg der Emissionshöhen von Wolkeblitzen kommt.

9. Verfahren nach Anspruch 8, **dadurch gekennzeichnet, dass** die Blitzsignalanalyse Daten betreffend Blitzaktivität und/oder Blitzanzahl bzw. Blitzintensität und/oder Blitzstärke und/oder Ort und/oder Bewegungsrichtung und/oder Bewegungsgeschwindigkeit der Blitze und/oder Wolke-Blitze und Boden-Blitze aufweist.

10. Verfahren nach Anspruch 8 oder Anspruch 9, **dadurch gekennzeichnet, dass** wenigstens auf zwei unterschiedliche Ermittlungsarten jeweils unabhängig voneinander ein Blitzsprungereignis (J1, J2) ermittelt wird und ein Blitzsprungereignis (J1, J2) erst dann ermittelt wird, wenn gemäß beiden Ermittlungsarten ein Blitzsprungereignis (J1, J2) ermittelt wurde.

11. Verfahren nach einem der Ansprüche 8 bis 10, **dadurch gekennzeichnet, dass** anhand der zeitlichen Koordinaten des Blitzsprungereignisses (J1, J2) Ortskoordinaten des Blitzsprungereignisses (J1, J2) ermittelt werden.

12. Verfahren nach Anspruch 11, **dadurch gekennzeichnet, dass** ausgehend von den ermittelten Ortskoordinaten des Blitzsprungereignisses (J1, J2) wenigstens ein wahrscheinliches Hagelniederschlagsgebiet (G) identifizierbar ist.

13. Verfahren nach einem der Ansprüche 8 bis 12, **dadurch gekennzeichnet, dass** ein mögliches Hagelniederschlagsgebiet (G) zusätzlich anhand von Signalen betreffend Blitze im Zeitraum nach dem Blitzsprungereignis (J1, J2) eingegrenzt wird.

## Claims

1. A system (10) for the identification and/or prediction of hail events which comprises a plurality of measuring stations (12, 12*) for detecting signals relating to electromagnetic radiation associated with lightning, at least one time measuring device (24) for detecting the chronological sequence of the detected signals, at least one analysis unit (26) connected to the measuring stations (12, 12*) and the time measuring device (24), wherein the analysis unit (26) comprises at least a first lightning signal analysis module (28) for generating a lightning signal analysis on the basis of the detected signals,
wherein the analysis unit (26) comprises a second lightning signal analysis module (30) for identifying at least one lightning jump event (J1, J2) based on the chronological sequence of the detected signals and the lightning signal analysis, and the analysis unit (26) comprises a nowcasting module (32) (J1, J2) for predicting a hail event on the basis of a lightning jump event,
**characterized in that**
the lightning signal analysis comprises data relative to the altitude of the lightning, in particular a distribution of the lightning altitude, wherein the emission altitude of intra-cloud lightning is factored into the identifying of the lightning jump event, and wherein defined as a lightning jump event is an event involving a sharp increase in lightning activity and/or a sharp increase in the emission altitude of intra-cloud lightning.

2. The system (10) according to claim 1, **characterized in that** the lightning signal analysis comprises data relative to the lightning activity and/or the number of lightning bolts or the intensity of the lightning respectively and/or the lightning force and/or the location and/or direction of movement and/or speed of travel of the lightning.

3. The system (10) according to claim 1 or claim 2, **characterized in that** the lightning signal analysis comprises data relative to intra-cloud lightning and cloud-to-ground lightning.

4. The system (10) according to one of the preceding claims, **characterized in that** the second lightning signal analysis module (30) comprises at least one first comparison element (34) and at least one second comparison element (36), wherein the first and second comparison element (34, 36) can detect a lightning jump event (J1, J2) independently of each other, and a lightning jump event (J1, J2) is identified by the second lightning signal analysis module (30) when both comparison elements detect a lightning jump event (J1, J2).

5. The system (10) according to one of the preceding claims, **characterized in that** the spatial coordinates of the lightning jump event (J1, J2) can be determined by the second lightning signal analysis module (30) based on the temporal coordinates of the lightning jump event (J1, J2).

6. The system (10) according to claim 5, **characterized in that** an at least probable hail-event area (G) can be identified by the second lightning signal analysis module (30) based on the detected spatial coordinates of the lightning jump event.

7. The system (10) according to one of the preceding claims, **characterized in that** the second lightning signal analysis module (30) can additionally limit a probable hail-event area (G) based on signals associated with lightning during the period following the lightning jump.

8. A method (10) for the identification and/or prediction of hail events, wherein the method comprises at least the following steps:
- detecting signals relating to electromagnetic radiation associated with lightning;
- determining a chronological sequence of the detected signals;
- generating a lightning signal analysis based on the detected signals which comprises data relative to the lightning activity and/or the number of lightning bolts and/or the intensity of the lightning and/or the emission altitude of the lightning and/or the location and/or direction of movement and/or speed of travel of the lightning;
wherein at least one lightning jump event (J1, J2) is identified on the basis of the lightning signal analysis and a hail event is predicted on the basis of a lightning jump event (J1, J2), **characterized in that** the lightning signal analysis comprises data relative to the altitude of the lightning, in particular a distribution of the lightning altitude, wherein the emission altitude of intra-cloud lightning is factored into the identifying of the lightning jump event, and wherein defined as a lightning jump event is an event involving a sharp increase in lightning activity and/or a sharp increase in the emission altitude of intra-cloud lightning.

9. The method (10) according to claim 8, **characterized in that** the lightning signal analysis comprises data relative to the lightning activity and/or the number of lightning bolts or the intensity of the lightning respectively and/or the lightning force and/or the location and/or direction of movement and/or speed of travel of the lightning and/or intra-cloud lightning and cloud-to-ground lightning.

10. The method (10) according to claim 8 or claim 9, **characterized in that** a lightning jump event (J1, J2) is in each case independently identified by at least two different types of determination and a lightning jump event (J1, J2) is only determined when both types of determination have determined a lightning jump event (J1, J2).

11. The method (10) according to one of claims 8 to 10, **characterized in that** the spatial coordinates of the lightning jump event (J1, J2) are determined on the basis of the temporal coordinates of the lightning jump event (J1, J2).

12. The method (10) according to claim 11, **characterized in that** an at least probable hail-event area (G) can be identified on the basis of the detected spatial coordinates of the lightning jump event (J1, J2).

13. The method (10) according to one of claims 8 to 12, **characterized in that** a probable hail-event area (G) is additionally limited on the basis of signals associated with lightning during the period following the lightning jump event (J1, J2).

## Revendications

1. Système (10) d'identification et/ou de prévision d'épisodes de grêle à l'aide de plusieurs stations de mesure (12, 12*) permettant d'enregistrer des signaux relatifs au rayonnement électromagnétique en rapport avec des éclairs, avec au moins un dispositif de mesure de temps (24) permettant d'enregistrer la trajectoire dans le temps des signaux détectés, avec au moins une unité d'analyse (26) reliée aux stations de mesure (12, 12*) et au dispositif de mesure de temps (24), l'unité d'analyse (26) comportant au moins un premier module d'analyse de signal d'éclair (28) permettant de réaliser une analyse de signal d'éclair sur la base des signaux détectés ;
l'unité d'analyse (26) comportant un deuxième module d'analyse de signal d'éclair (30) pour l'identification d'au moins un épisode de saut d'éclair (J1, J2) sur la base de la trajectoire dans le temps des signaux détectés et de l'analyse de signal d'éclair et l'unité d'analyse (26) comportant un module de prévision (32) (J1, J2) produisant une prévision concernant un épisode de grêle sur la base d'un épisode de saut d'éclair ;
**caractérisé en ce que** :
l'analyse de signal d'éclair comporte des données relatives à la hauteur des éclairs, notamment une répartition en hauteur des éclairs, sachant que lors de l'identification de l'épisode de saut d'éclair, la hauteur d'émission des éclairs intra-nuage est incluse et l'épisode de saut d'éclair étant défini comme un épisode au cours duquel il se produit une forte hausse de l'activité d'éclairs et/ou une forte hausse des hauteurs d'émission des éclairs intra-nuage.

2. Système (10) selon la revendication 1, **caractérisé en ce que** l'analyse de signal d'éclair comprend des données relatives à l'activité d'éclairs et/ou au nombre d'éclairs et/ou à l'intensité d'éclair et/ou à la puissance d'éclair et/ou au lieu et/ou à la direction de déplacement et/ou à la vitesse de déplacement des éclairs.

3. Système (10) selon la revendication 1 ou 2, **caractérisé en ce que** l'analyse de signal d'éclair comporte des données relatives aux éclairs intra-nuage et à la foudre au sol.

4. Système (10) selon l'une quelconque des revendications précédentes, **caractérisé en ce que** le deuxième module d'analyse de signal d'éclair (30) comporte au moins un premier élément de comparaison (34) et au moins un deuxième élément de comparaison (36), un épisode de saut d'éclair (J1, J2) étant respectivement déterminé à l'aide du premier et du deuxième élément de comparaison (34, 36) indépendamment l'un de l'autre et le deuxième module d'analyse de signal d'éclair (30) permettant de calculer un épisode de saut d'éclair (J1, J2) lorsque les deux éléments de comparaison déterminent un épisode de saut d'éclair (J1, J2).

5. Système (10) selon l'une quelconque des revendications précédentes, **caractérisé en ce que** des coordonnées d'emplacement de l'épisode de saut d'éclair (J1, J2) sont déterminées à l'aide du deuxième module d'analyse de signal d'éclair (30) à l'aide des coordonnées dans le temps de l'épisode de saut d'éclair (J1, J2).

6. Système (10) selon la revendication 5, **caractérisé en ce qu'**au moins une zone de chute de grêle (G) probable peut être identifiée à l'aide du deuxième module d'analyse de signal d'éclair (30) à partir des coordonnées d'emplacement déterminées de l'épisode de saut d'éclair.

7. Système (10) selon l'une quelconque des revendications précédentes, **caractérisé en ce qu'**une possible zone de chute de grêle (G) peut en outre être localisée pendant la période suivant le saut d'éclair à l'aide de signaux relatifs aux éclairs grâce au deuxième module d'analyse de signal d'éclair (30).

8. Procédé d'identification et/ou de prévision d'épisodes de grêle, le procédé comprenant au moins les étapes suivantes :
- détection des signaux concernant le rayonnement électromagnétique en rapport avec des éclairs ;
- détection de la trajectoire dans le temps des signaux détectés ;
- sur la base des signaux détectés, analyse du signal d'éclair comprenant des données relatives à l'activité d'éclairs et/ou au nombre d'éclairs et/ou à la puissance d'éclair et/ou à la hauteur d'émission des éclairs et/ou au lieu et/ou à la direction de déplacement et/ou à la vitesse de déplacement des éclairs ;
au moins un épisode de saut d'éclair (J1, J2) étant identifié sur la base de l'analyse de signal d'éclair et une prévision concernant un épisode de grêle étant mise à disposition sur la base d'un épisode de saut d'éclair (J1, J2) ;
**caractérisé en ce que** l'analyse de signal d'éclair comporte des données relatives à la hauteur des éclairs, notamment une répartition en hauteur des éclairs, la hauteur d'émission des éclairs intra-nuage étant incluse lors de l'identification de l'épisode de saut d'éclair et un épisode de saut d'éclair étant défini comme un épisode au cours duquel il se produit une forte hausse de l'activité d'éclairs et/ou une forte hausse des hauteurs d'émission des éclairs intra-nuage.

9. Procédé selon la revendication 8, **caractérisé en ce que** l'analyse de signal d'éclair comporte des données relatives à l'activité d'éclairs et/ou au nombre d'éclairs et/ou à l'intensité d'éclair et/ou à la puissance d'éclair et/ou au lieu et/ou à la direction de déplacement et/ou à la vitesse de déplacement des éclairs et/ou des éclairs intra-nuage et de la foudre.

10. Procédé selon la revendication 8 ou la revendication 9, **caractérisé en ce qu'**un épisode de saut d'éclair (J1, J2) est déterminé suivant au moins deux types de calcul différents respectivement indépendants l'un de l'autre et qu'un épisode de saut d'éclair (J1, J2) est d'abord déterminé lorsqu'un épisode de saut d'éclair (J1, J2) est déterminé en fonction des deux types de calcul.

11. Procédé selon l'une quelconque des revendications 8 à 10, **caractérisé en ce que** des coordonnées d'emplacement de l'épisode de saut d'éclair (J1, J2) sont déterminées à l'aide des coordonnées dans le temps de l'épisode de saut d'éclair (J1, J2).

12. Procédé selon la revendication 11, **caractérisé en ce qu'**au moins une zone de chute de grêle (G) probable peut être identifiée à partir des coordonnées d'emplacement déterminées de l'épisode de saut d'éclair (J1, J2).

13. Procédé selon l'une quelconque des revendications 8 à 12, **caractérisé en ce qu'**une zone de chute de grêle (G) possible est en outre localisée à l'aide de signaux relatifs aux éclairs pendant la période suivant l'épisode de saut d'éclair (J1, J2).
